# EUROPEAN PATENT APPLICATION

(11) **EP 2 194 588 A2**
(43) Date of publication of application: **09.06.2010**
(21) Application number: 09166827.7
(22) Date of filing: 30.07.2009
(51) Int. Cl.: H01L 33/44, H01L 33/58, H01L 25/16, H01L 33/50

(54) **Light emitting device and method for manufacturing same**

(30) Priority: 03.12.2008 JP 2008308641
(71) Applicant: KABUSHIKI KAISHA TOSHIBA, Tokyo (JP)
(72) Inventor: Komatsu, Tetsuro, Tokyo (JP); Tamura, Hideo, Tokyo (JP)
(74) Representative: HOFFMANN EITLE

(57) **Abstract**

A light emitting device includes: a substrate including through electrodes; a light emitting element bonded onto the substrate and connected to the through electrodes; and a dielectric film made of a translucent inorganic material and spaced from the light emitting element so that an internal space is formed between the dielectric film and the substrate, emission light from the light emitting element being allowed to be emitted through the dielectric film, and a manufacturing the same are provided.

## Description

### CROSS-REFERENCE TO RELATED APPLICATION

This application is based upon and claims the benefit of priority from the prior Japanese Patent Application No.2008-308641, filed on December 3, 2008; the entire contents of which are incorporated herein by reference.

### BACKGROUND OF THE INVENTION

### Field of the Invention

This invention relates to a light emitting device and a method for manufacturing the same.

### Background Art

Light emitting devices capable of emitting visible and white light are expanding their applications to, for example, illumination devices, display devices, and backlight sources for image display devices.

In these applications, there is a growing demand for downsizing. In this context, an SMD (surface-mounted device) light emitting device is used, in which a light emitting element chip is bonded onto a lead frame and resin-molded.

To replace fluorescent lamps and incandescent bulbs by illumination devices based on semiconductor light emitting devices having low power loss, it is necessary to enhance mass productivity and reduce cost.

JP-A-2006-128625(Kokai) discloses an example technique for further downsizing. In this example technique, a light emitting element chip is flip-chip connected to an interconnect layer provided on a transparent substrate so as to be externally driven through a columnar electrode and a ball. On the transparent substrate, the light emitting element chip and the columnar electrode are covered with a sealant.

However, in this example technique, it is difficult to decrease the distance between the light emitting element chip and the lens, or between the light emitting element chip and the phosphor layer. Hence, there is a limit to the reduction of size and thickness. Furthermore, mass productivity is insufficient.

### SUMMARY OF THE INVENTION

According to an aspect of the invention, there is provided a light emitting device including: a substrate including through electrodes; a light emitting element bonded onto the substrate and connected to the through electrodes; and a dielectric film made of a translucent inorganic material and spaced from the light emitting element so that an internal space is formed between the dielectric film and the substrate, emission light from the light emitting element being allowed to be emitted through the dielectric film.

According to another aspect of the invention, there is provided a method for manufacturing a light emitting device, including: forming a light emitting element including a multilayer body having a light emitting layer, and a p-side electrode and an n-side electrode connected to the multilayer body; bonding the light emitting element to an upper surface of a substrate including through electrodes and electrically connecting the p-side electrode and the n-side electrode respectively to the through electrodes; forming an organic film so as to cover at least a side surface of the light emitting element and the upper surface of the substrate; forming a first dielectric film made of a translucent inorganic material so as to cover the organic film; and removing the organic film through an opening provided in the first dielectric film, and then sealing the opening with a second dielectric film made of a translucent inorganic material.

According to another aspect of the invention, there is provided a light emitting device including: a light emitting element including a translucent substrate, a multilayer body having a first surface adjacent to a first surface of the translucent substrate and having a light emitting layer, and a p-side electrode and an n-side electrode formed on a second surface opposite to the first surface of the multilayer body; a substrate including through electrodes to which the p-side electrode and the n-side electrode are respectively connected by bumps; a phosphor layer provided so as to cover at least a second surface opposite to the first surface of the translucent substrate and being operable to absorb emission light from the light emitting element and emit wavelength-converted light having a longer wavelength than the emission light; and a dielectric film provided on the substrate, enclosing the phosphor layer, the light emitting element, and the bumps, and made of a translucent inorganic material, the dielectric film having a lens surface capable of at least one of convergence and divergence of the emission light and the wavelength-converted light.

### BRIEF DESCRIPTION OF THE DRAWINGS

FIG. 1 is a schematic cross-sectional view of a light emitting device according to a first embodiment;
FIGS. 2A to 2D are process cross-sectional views of the first embodiment;
FIGS. 3A to 3C are process cross-sectional views of the first embodiment;
FIGS. 4A to 4C are schematic cross-sectional views of variations of the first embodiment;
FIGS. 5A to 5D are process cross-sectional views of a light emitting device according to a second embodiment;
FIGS. 6A to 6C are process cross-sectional views of a light emitting device according to a third embodiment
FIGS. 7A and 7B show variations of the third embodiment;
FIGS. 8A to 8C are schematic cross-sectional views of a light emitting device according to a fourth embodiment;
FIGS. 9A to 9C are process cross-sectional views of a light emitting device according to a fifth embodiment;
FIGS. 10A to 10C are process cross-sectional views of a light emitting device according to a sixth embodiment;
FIGS. 11A and 11B are schematic cross-sectional views of a light emitting device according to a seventh embodiment;
FIG. 12 is a schematic cross-sectional view of a light emitting device according to an eighth embodiment; and
FIG. 13 is a schematic cross-sectional view of a light emitting device according to a ninth embodiment.

### DETAILED DESCRIPTION OF THE INVENTION

Embodiments of the invention will now be described with reference to the drawings.

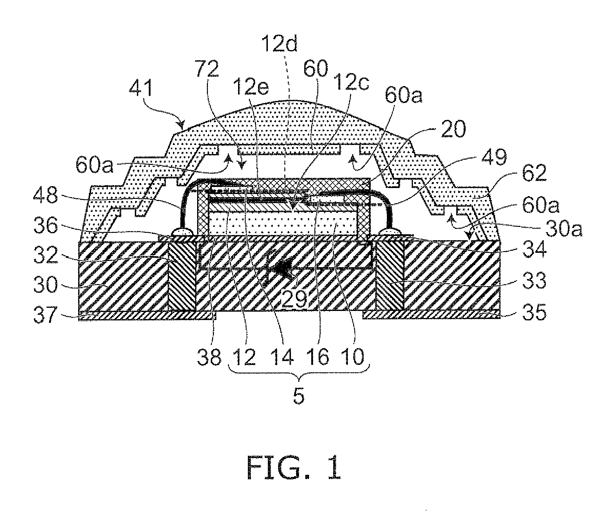

FIG. 1 is a schematic cross-sectional view of a light emitting device according to a first embodiment.

The light emitting element 5 includes a translucent substrate 10, a multilayer body 12 having a first surface 12c adjacent to the translucent substrate 10 and including a light emitting layer 12e, and a p-side electrode 14 and an n-side electrode 16 formed on a second surface 12d opposite to the first surface 12c of the multilayer body 12.

The multilayer body 12 has a structure in which an n-type layer, an n-type cladding layer, the light emitting layer 12e, a p-type cladding layer and the like are stacked in this order from the translucent substrate 10 side, for example. Here, the conductivity type is not limited thereto, but may be the opposite conductivity type.

The n-side electrode 16 and the p-side electrode 14 are provided on the second surface 12d of the multilayer body 12 having a step difference.

A substrate 30 includes through electrodes 32, 33, and the chip of the light emitting element 5 is bonded to a conductive portion 38 provided on an upper surface 30a of the substrate 30 using an adhesive such as a conductive paste. The p-side electrode 14 provided on the second surface 12d of the multilayer body 12 is connected to a conductive portion 36 provided on the upper surface 30a of the substrate 30 including the through electrodes by a bonding wire 48. Furthermore, the n-side electrode 16 provided on the second surface 12d of the multilayer body 12 is connected to a conductive portion 34 provided on the upper surface 30a of the substrate 30 by a bonding wire 49.

A phosphor layer 20 is provided so as to cover the chip of the light emitting element 5. Furthermore, a first dielectric film 60 having an opening and spaced from the phosphor layer 20, and a second dielectric film 62 sealing the opening 60a are provided. As shown in this figure, the upper surface of the second dielectric film 62 can also be curved and shaped into a convex lens 41.

In this embodiment, an internal space 72 is provided in the vicinity of the chip of the light emitting element 5. This facilitates bonding the chip with the second surface 12d of the multilayer body 12 facing upward, and wiring the bonding wires 48, 49 to the conductive portions 34, 36 without contact with the first dielectric film 60.

In the light emitting device of FIG. 1, emission light from the light emitting element 5, and wavelength-converted light having a longer wavelength than the emission light and emitted from the phosphor layer 20 that has absorbed the emission light, can be emitted upward through the first and second dielectric film 60, 62. Thus, white or warm white light, for example, can be readily obtained as mixed light thereof. However, the invention is not limited thereto, but also includes a light emitting device without a phosphor layer, in which the emission light from the light emitting element 5 can be emitted upward through the first and second dielectric film 60, 62.

In the case where the substrate 30 including the through electrodes is made of high-resistivity Si, a Zener diode 29 can be embedded therein and interconnected to the conductive portions 34, 36. This facilitates protecting the light emitting element 5 when an excessive voltage occurs in the light emitting element 5. Alternatively, the substrate 30 can be a semiconductor substrate illustratively made of Si or SiC, or an insulating substrate illustratively made of sapphire.

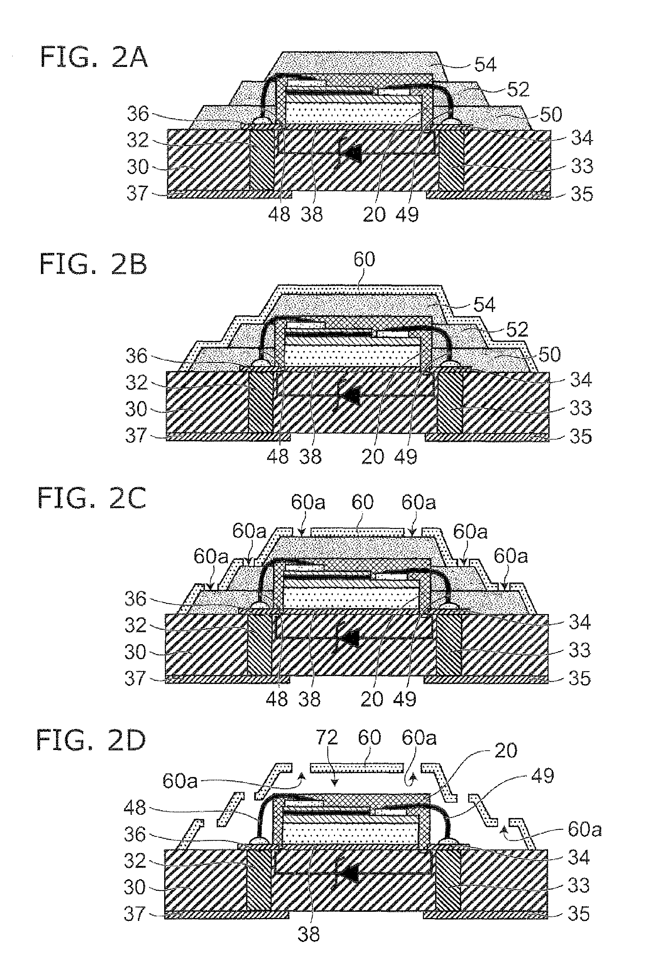

FIGS. 2A to 2D show steps of a manufacturing method of the first embodiment until forming a first dielectric film having an internal space. The substrate 30 made of Si or other semiconductor is provided with through electrodes 32, 33 and conductive portions 34, 35, 36, 37, 38. A light emitting element 5 is mounted with a solder paste, a resin paste or the like, and wire-bonded using an Au wire or the like. A liquid glass mixed with phosphor particles is applied and heat-cured to form a phosphor layer 20. Furthermore, a first organic film 50, a second organic film 52 smaller than the first organic film 50, and a third organic film 54 smaller than the second organic film 52, for example, are sequentially stacked so as to cover the phosphor layer 20 (FIG. 2A). The organic film can illustratively be an organic film having a polymer structure.

Further thereon, a first dielectric film 60 made of an inorganic material such as SiO₂ is formed to e.g. approximately 1 µm (FIG. 2B), and an opening 60a large enough to dry etch the internal organic films is formed (FIG. 2C). Subsequently, the first to third organic film 50, 52, 54 are removed by dry etching and the like (FIG. 2D).

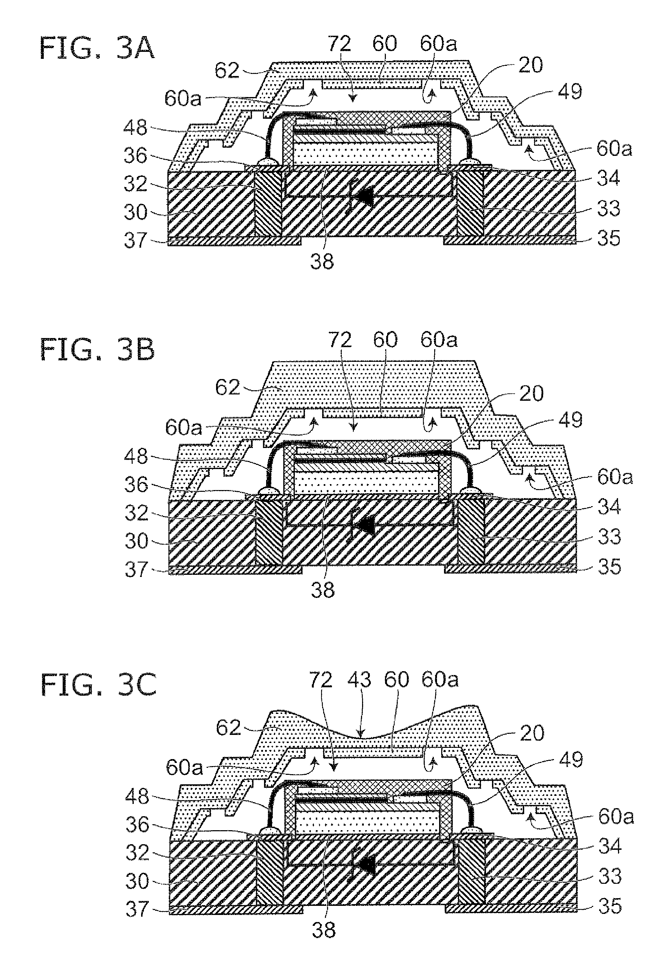

FIGS. 3A to 3C show a subsequent process until forming a lens.

After the first to third organic film 50, 52, 54 are etched, a second dielectric film 62 made of an inorganic material such as SiO₂ is formed to e.g. approximately 3 µm on the first dielectric film 60 having the opening 60a. Then, the opening 60a of the first dielectric film 60 is sealed (FIG. 3A). If there is no need to converge or diverge the emission light from the light emitting element or the mixed light, the structure of FIG. 3A can emit the mixed light upward.

In the case of converging or diverging the emission light or mixed light, a process for forming a lens is further performed. More specifically, the second dielectric film 62 is thickened to e.g. 5-10 µm (FIG. 3B).

Subsequently, a convex lens 41 is illustratively formed by dry etching with low selective ratio for the resist. Then, a light emitting device as shown in FIG. 1 is completed, in which light is readily converged to achieve high brightness.

On the other hand, if a concave lens 43 is formed, a light emitting device as shown in FIG. 3C is completed, in which light is readily diverged.

Thus, in this embodiment, the assembly process using a light emitting element chip at wafer level, such as in the form of a Si substrate, can be readily performed. Furthermore, an inspection process can be performed at wafer level. Such a light emitting device is referred to as a WLP (wafer-level package) light emitting device. The WLP light emitting device can be downsized close to the bare chip size of the light emitting element, and hence can be called CSP (chip size package). Furthermore, the WLP light emitting device facilitates enhancing the mass productivity of the manufacturing process, and consequently can achieve cost reduction. Thus, the WLP light emitting device having small size and high mass productivity can be widely used in, for example, illumination devices, display devices, and backlight sources for image display devices.

Furthermore, this light emitting device is sealed with the substrate including the through electrodes 32, 33 and illustratively made of Si, and the second dielectric film 62 made of an inorganic material. Thus, this embodiment can improve hermeticity and water resistance, and facilitates further enhancement in reliability.

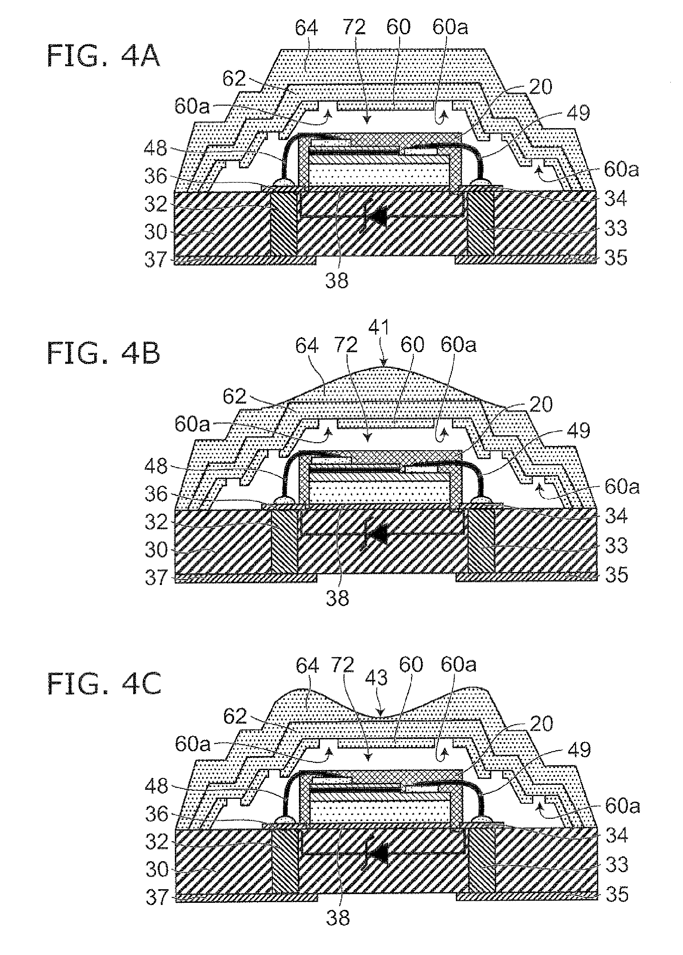

FIGS. 4A to 4C are schematic cross-sectional views of light emitting devices of variations of the first embodiment.

A third dielectric film 64 made of an inorganic material different from the second dielectric film 62 is further provided to a thickness of e.g. 2-7 µm. Thus, the lens can be processed more reliably (FIG. 4A). The material thereof can be quartz glass, for example. If a surface of the third dielectric film 64 is curved into a convex lens 41, light can be converged (FIG. 4B). If the surface is curved into a concave lens 43, light can be diverged (FIG. 4C).

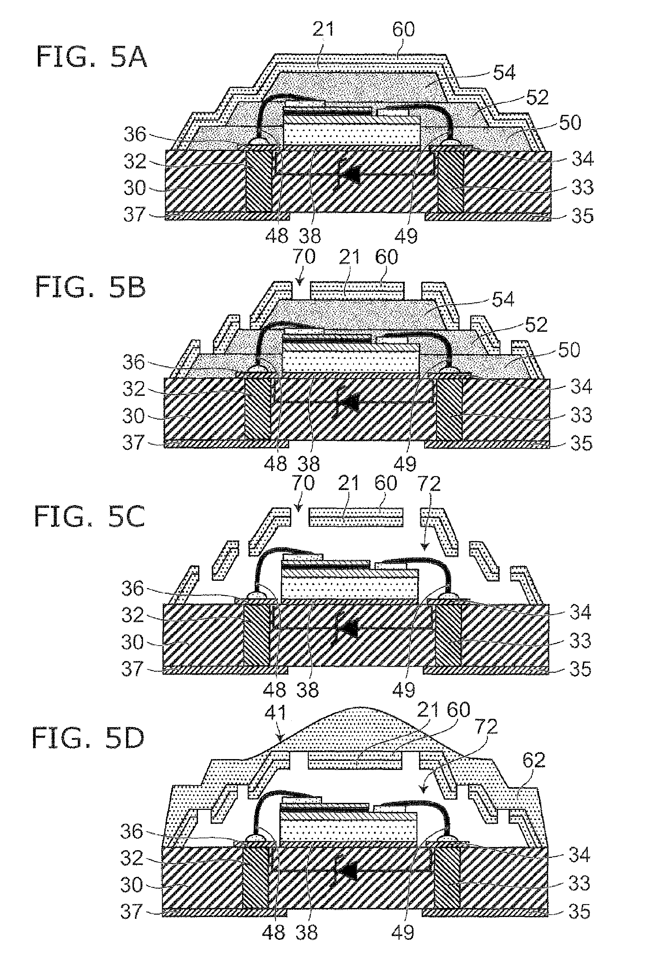

FIGS. 5A to 5D are process cross-sectional views of a light emitting device according to a second embodiment.

A light emitting element is mounted on a first surface 30a of a substrate 30 including through electrodes, The light emitting element is wire-bonded, and then covered with a first to third organic film 50, 52, 54. Furthermore, a phosphor layer 21 and a first dielectric film 60 are formed in this order so as to cover the first to third organic film 50, 52, 54 (FIG. 5A).

Subsequently, an opening 70 is formed in the first dielectric film 60 and the phosphor layer 21 (FIG. 5B).

The first to third organic film 50, 52, 54 are removed through an opening 70 by dry etching and the like to form an internal space 72 (FIG. 5C). Formation of the internal space 72 serves to prevent deformation of bonding wires 48, 49. Subsequently, a second dielectric film 62 is formed to seal the opening 70. Here, if the second dielectric film 62 is formed thick, a convex lens 41 or concave lens can be readily formed, and convergence or divergence of emission light can be controlled (FIG. 5D).

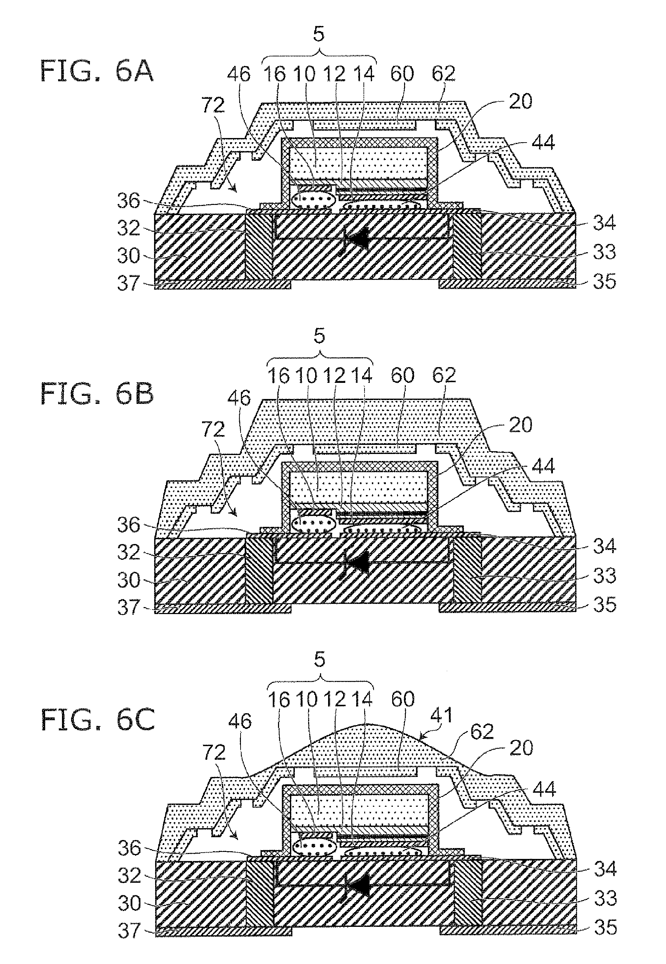

FIGS. 6A to 6C are process cross-sectional views of a light emitting device according to a third embodiment.

In this embodiment, the light emitting element 5 is flip-chip connected. More specifically, conductive portions 34, 36 are provided on a first surface 30a of a substrate 30 including through electrodes, and conductive portions 35, 37 are provided on a second surface 30b thereof. The conductive portion 34 provided on the first surface 30a and the conductive portion 35 provided on the second surface 30b are connected by the through electrode 33. The conductive portion 36 provided on the first surface 30a and the conductive portion 37 provided on the second surface 30b are connected by the through electrode 32.

The p-side electrode 14 of the light emitting element 5 and the conductive portion 34 provided on the first surface 30a of the substrate 30 including the through electrodes are flip-chip connected by a bump 44. The n-side electrode 16 of the light emitting element 5 and the conductive portion 36 provided on the first surface 30a of the substrate 30 are flip-chip connected by a bump 46. They are connected through the through electrodes 32, 33 to the conductive portions 35, 37 provided on the second surface 30b of the substrate 30, respectively. Furthermore, a phosphor layer 20 is formed illustratively by sputtering, or applying a liquid glass mixed with phosphor particles, so as to enclose the light emitting element 5.

Then, by a process similar to that of the first embodiment, an internal space 72 is formed (FIG. 6A). Furthermore, the same inorganic material as the second dielectric film 62 is used to increase its thickness to e.g. approximately 5-10 µm (FIG. 6B). Furthermore, the second dielectric film 62 is processed into a lens (FIG. 6C). Although this figure shows a convex lens 41, a concave lens can also be readily formed.

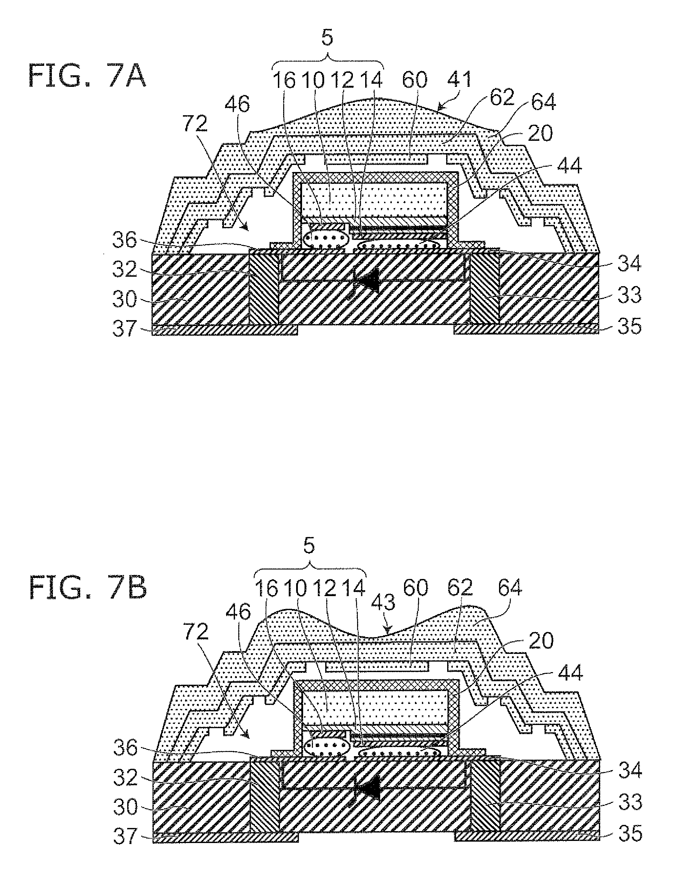

FIGS. 7A and 7B show variations of the third embodiment. A third dielectric film 64 made of an inorganic material different from the material of the second dielectric film 62 is formed to a thickness of e.g. approximately 2-7 µm so as to cover the second dielectric film 62, and its surface is further formed into a lens surface. FIG. 7A shows a convex lens 41, and FIG. 7B shows a concave lens 43.

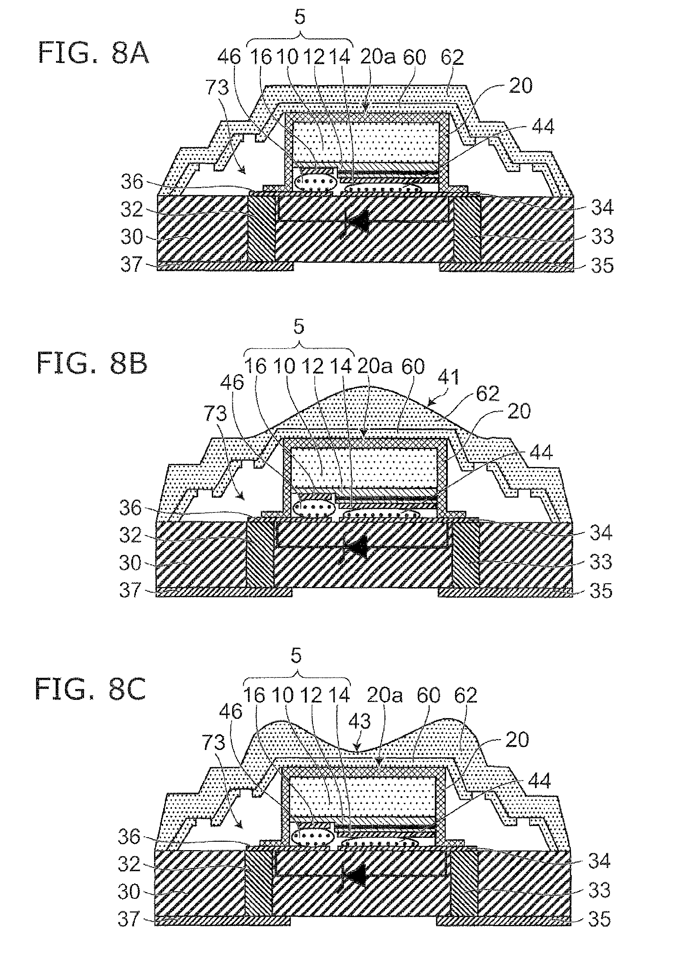

FIGS. 8A to 8C are schematic cross-sectional views of a light emitting device according to a fourth embodiment.

In this embodiment, the first dielectric film 60 is formed adjacent to the upper surface 20a of the phosphor layer 20 (FIG. 8A). Thus, an internal space 73 is formed on the lateral side of the light emitting element 5. This can strengthen the stacked structure of the first dielectric film 60 and the second dielectric film 62, improving the lens fixation strength. FIG. 8B shows a convex lens 41, and FIG. 8C shows a concave lens 43. Here, the convex lens 41 and the concave lens 43 may be formed from a third dielectric film, which is different in material from the second dielectric film 62.

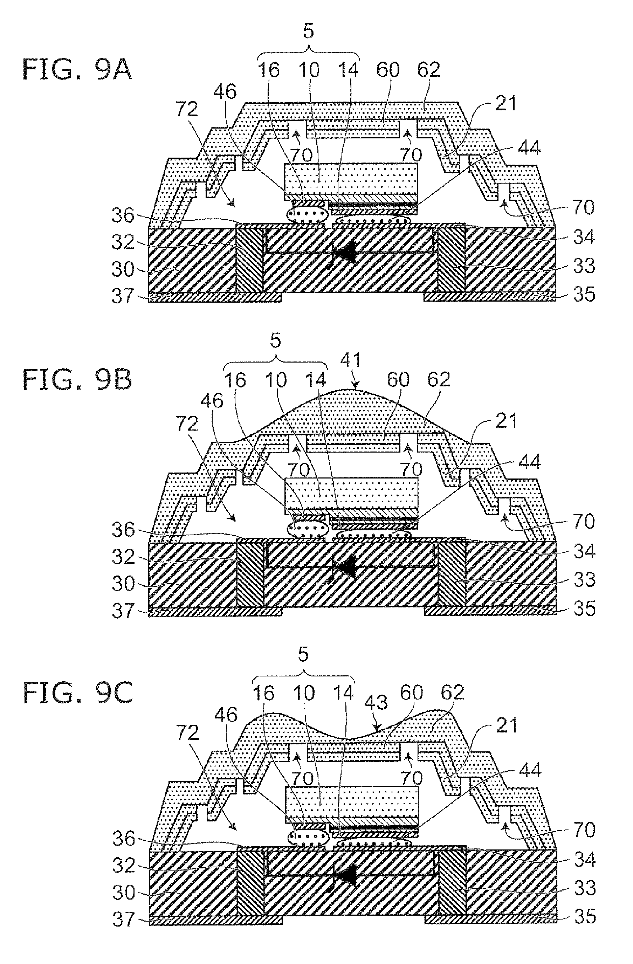

FIGS. 9A to 9C are process cross-sectional views of a light emitting device according to a fifth embodiment.

In this embodiment, like the second embodiment, a phosphor layer 21 is formed so as to cover the inner wall of the first dielectric film 60 having an opening 70 (FIG. 9A). After the second dielectric film 62 is further thickened, a lens surface is formed. FIG. 9B shows a convex lens 41, and FIG. 9C shows a concave lens 43. Here, the convex lens 41 and the concave lens 43 may be formed from a third dielectric film, which is different in material from the second dielectric film 62.

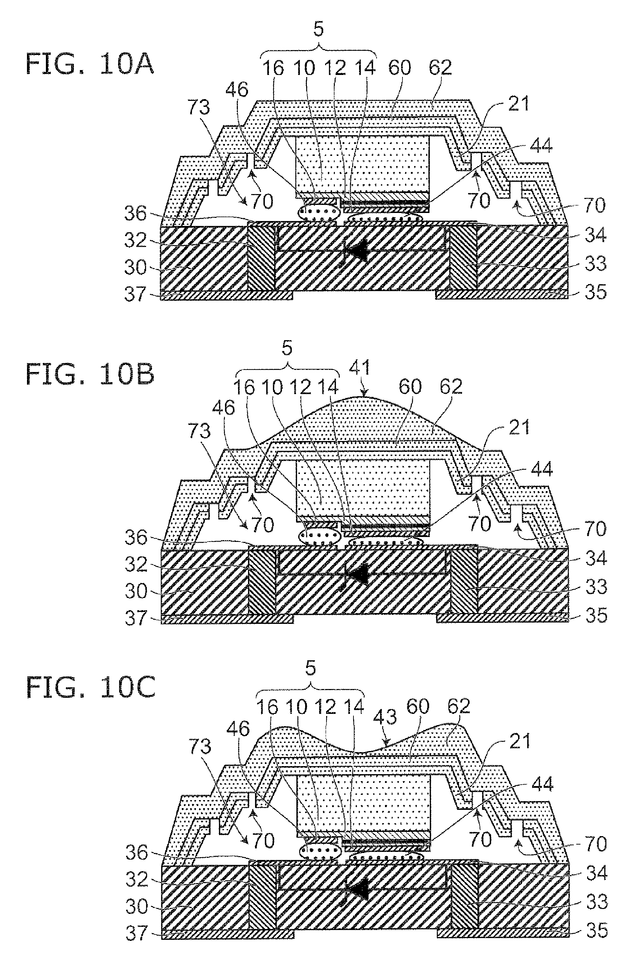

FIGS. 10A to 10C are process cross-sectional views of a light emitting device according to a sixth embodiment.

In this embodiment, a phosphor layer 21 and the translucent substrate 10 are formed adjacently (FIG. 10A). Thus, an internal space 73 is formed on the lateral side of the light emitting element 5. This can strengthen the stacked structure of the first and second dielectric film 60, 62, improving the lens fixation strength. After the second dielectric film 62 is further thickened, a lens surface is formed. FIG. 10B shows a convex lens 41, and FIG. 10C shows a concave lens 43. Here, the convex lens 41 and the concave lens 43 may be formed from a third dielectric film, which is different in material from the second dielectric film 62.

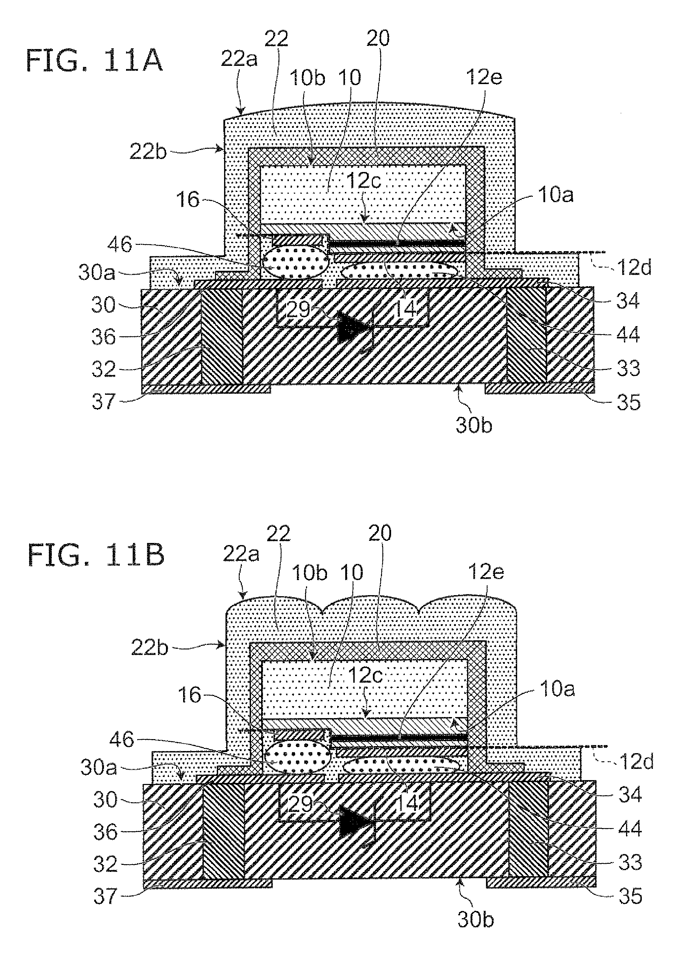

FIG. 11A is a schematic cross-sectional view of a light emitting device according to a seventh embodiment, and FIG. 11B is a schematic cross-sectional view of a variation thereof.

The light emitting element includes a translucent substrate 10, a multilayer body 12 having a first surface 12c adjacent to a first surface 10a of the translucent substrate 10 and including a light emitting layer 12e, and a p-side electrode 14 and an n-side electrode 16 formed on a second surface 12d of the multilayer body 12.

The multilayer body 12 includes an n-type layer, an n-type cladding layer, the light emitting layer 12e, a p-type cladding layer and the like. Here, the conductivity type is not limited thereto, but may be the opposite conductivity type.

The n-side electrode 16 and the p-side electrode 14 are provided on the second surface 12d of the multilayer body 12 having a step difference.

On the other hand, conductive portions 34, 36 are provided on an upper surface (first surface) 30a of a substrate 30 including through electrodes, and conductive portions 35, 37 are provided on a second surface 30b thereof. The conductive portion 34 provided on the first surface 30a and the conductive portion 35 provided on the second surface 30b are connected by the through electrode 33. The conductive portion 36 provided on the first surface 30a and the conductive portion 37 provided on the second surface 30b are connected by the through electrode 32.

The p-side electrode 14 of the light emitting element and the conductive portion 34 provided on the first surface 30a of the substrate 30 including the through electrodes are flip-chip connected by a bump 44. The n-side electrode 16 of the light emitting element and the conductive portion 36 provided on the substrate 30 including the through electrodes are flip-chip connected by a bump 46. They are connected through the through electrodes 32, 33 to the conductive portions 35, 37 provided on the second surface 30b of the substrate 30, respectively.

A phosphor layer 20 is formed illustratively by sputtering, or applying a liquid glass mixed with phosphor particles, so as to enclose the light emitting element. Furthermore, a dielectric film 22 being translucent and made of an inorganic material such as SiO₂ and glass is provided on the substrate 30 so as to enclose the light emitting element, the bumps 44, 46 and the like. Because the dielectric film 22 is made of an inorganic material, a light emitting device can be realized with improved hermeticity and water resistance and enhanced reliability. Furthermore, a convex lens surface is formed in the upper surface 22a of the dielectric film 22 and can converge emission light.

Furthermore, for example, the light emitting layer 12e can be made of a nitride semiconductor, the translucent substrate 10 can be made of sapphire, and the substrate 30 can be made of silicon or the like. Furthermore, if the phosphor layer 20 is made of a silicate-based yellow phosphor, white light or the like can be extracted from the upper surface 22a or the side surface 22b of the dielectric film 22 as mixed light of blue emission light from the light emitting layer 12e and yellow light, which is the wavelength-converted light from the yellow phosphor.

Furthermore, in the case where the substrate 30 including the through electrodes is made of silicon (Si), a Zener diode 29 can illustratively be embedded in the substrate 30 and interconnected between the conductive portion 34 and the conductive portion 36 provided on the first surface 30a of the substrate 30. Thus, the Zener diode 29 can be connected in parallel to the light emitting element. Hence, when an excessive voltage is applied to the light emitting element, a reverse current flows through the Zener diode 29, which facilitates protecting the light emitting element.

In FIG. 11A, the upper surface 22a of the dielectric film 22 is formed into a convex lens 41 surface. Alternatively, as shown in FIG. 11B, it is also possible to arrange convex lenses in an array. Further alternatively, arrayed concave lenses can also be used. Thus, this embodiment can readily achieve lower profile because it is free from the sealing resin and internal space. Furthermore, the manufacturing process is simplified, which facilitates enhancing the mass productivity.

In this embodiment and its variation, the light emitting device is formed using the substrate 30 made of Si. That is, the light emitting device, which can be subjected to the assembly process and the inspection process at wafer level using a light emitting element chip, is a WLP (wafer-level package) light emitting device. Hence, the light emitting device facilitates enhancing the mass productivity of the manufacturing process, and consequently can achieve cost reduction. Thus, the light emitting device having small size and high mass productivity can be widely used in, for example, illumination devices, display devices, and backlight sources for image display devices.

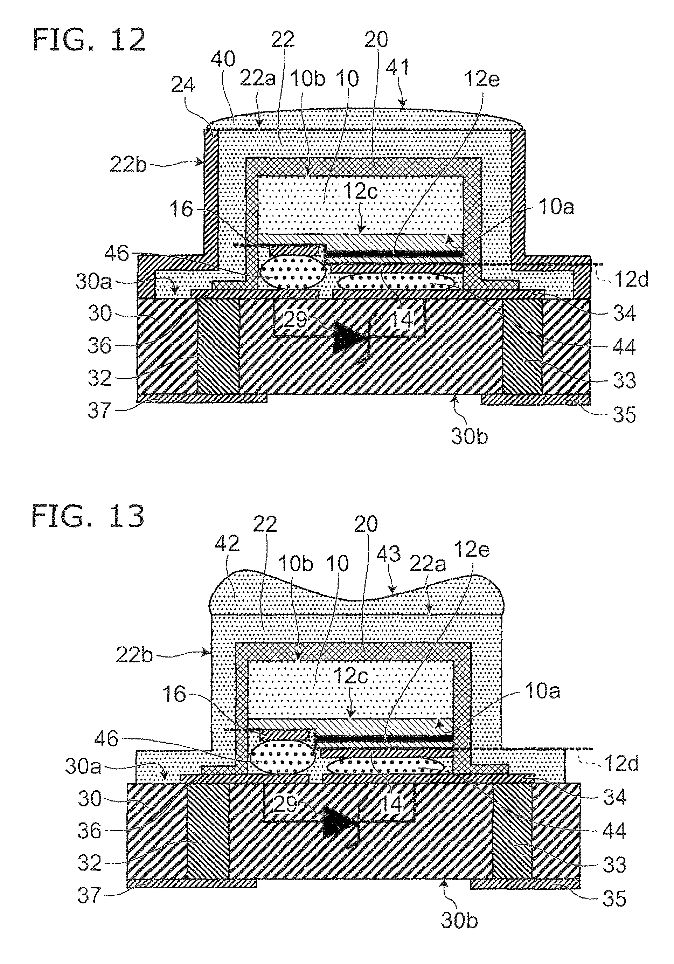

FIG. 12 is a schematic cross-sectional view of a light emitting device according to an eighth embodiment.

A convex lens 40 illustratively made of quartz glass is provided in an upper surface 22a of a dielectric film 22, and a reflecting film 24 is provided on a side surface 22b of the dielectric film 22. Emission light directed laterally from the light emitting element is reflected upward by the reflecting film 24. This facilitates enhancing the brightness above the device. The reflecting film can illustratively be a metal having high reflectance in the visible wavelength range, such as Al and Ag, a resin mixed with metal oxide particles, or a multilayer reflecting film illustratively made of SiO₂ or Si₃N₄.

FIG. 13 is a schematic cross-sectional view of a light emitting device according to a ninth embodiment.

A concave lens 42 illustratively made of quartz glass is provided in an upper surface 22a of a dielectric film 22 so that light directed upward can be laterally diverged. Furthermore, light can be readily spread laterally from a side surface 22b of the dielectric film 22. Hence, in application to a backlight source for an image display device, the emission light can be spread laterally to facilitate uniform emission from the light guide plate surface.

The embodiments of the invention have been described with reference to the drawings. However, the invention is not limited to these embodiments. Those skilled in the art can variously modify the size, material, shape, layout and the like of the light emitting element, multilayer body, phosphor layer, lens, organic film, dielectric film, translucent substrate, substrate, electrode, and bump constituting the embodiments of the invention, and such modifications are also encompassed within the scope of the invention as long as they do not depart from the spirit of the invention.

## Claims

1. A light emitting device comprising:
a substrate including through electrodes;
a light emitting element bonded onto the substrate and connected to the through electrodes; and
a dielectric film made of a translucent inorganic material and spaced from the light emitting element so that an internal space is formed between the dielectric film and the substrate,
emission light from the light emitting element being allowed to be emitted through the dielectric film.

2. The device according to claim 1, wherein the light emitting element includes a translucent substrate, a multilayer body having a first surface adjacent to the translucent substrate, and a p-side electrode and an n-side electrode formed on a second surface of the multilayer body opposite to the first surface.

3. The device according to claim 2, wherein the translucent substrate side is bonded to the substrate.

4. The device according to claim 2, wherein the p-side electrode and the n-side electrode are bonded to the substrate by bumps.

5. The device according to claim 4, wherein the dielectric film is spaced from at least a side surface of the light emitting element.

6. The device according to claim 3 or 4, further comprising:
a phosphor layer, provided so as to cover the light emitting element or provided on the internal space side of the dielectric film, and being operable to absorb the emission light and emit wavelength-converted light having a longer wavelength than the emission light,
the emission light and the wavelength-converted light being allowed to be emitted through the dielectric film.

7. The device according to claim 1, wherein the dielectric film has a lens surface capable of at least convergence and divergence of the emission light.

8. A method for manufacturing a light emitting device, comprising:
forming a light emitting element including a multilayer body having a light emitting layer, and a p-side electrode and an n-side electrode connected to the multilayer body;
bonding the light emitting element to an upper surface of a substrate including through electrodes and electrically connecting the p-side electrode and the n-side electrode respectively to the through electrodes;
forming an organic film so as to cover at least a side surface of the light emitting element and the upper surface of the substrate;
forming a first dielectric film made of a translucent inorganic material so as to cover the organic film; and
removing the organic film through an opening provided in the first dielectric film, and then sealing the opening with a second dielectric film made of a translucent inorganic material.

9. The method according to claim 8, wherein the forming an organic film includes further covering an upper surface of the light emitting element.

10. The method according to claim 8, further comprising:
before the forming an organic film, forming a phosphor layer so as to cover the light emitting element.

11. The method according to claim 8, wherein the forming a first dielectric film includes forming a phosphor layer between the organic film and the first dielectric film.

12. The method for according to claim 8, wherein the electrically connecting includes connecting the p-side electrode and the n-side electrode to the through electrodes by bumps.

13. The method according to claim 8, further comprising:
forming a lens in the second dielectric film.

14. A light emitting device comprising:
a light emitting element including a translucent substrate, a multilayer body having a first surface adjacent to a first surface of the translucent substrate and having a light emitting layer, and a p-side electrode and an n-side electrode formed on a second surface opposite to the first surface of the multilayer body;
a substrate including through electrodes to which the p-side electrode and the n-side electrode are respectively connected by bumps;
a phosphor layer provided so as to cover at least a second surface opposite to the first surface of the translucent substrate and being operable to absorb emission light from the light emitting element and emit wavelength-converted light having a longer wavelength than the emission light; and
a dielectric film provided on the substrate, enclosing the phosphor layer, the light emitting element, and the bumps, and made of a translucent inorganic material,
the dielectric film having a lens surface capable of at least one of convergence and divergence of the emission light and the wavelength-converted light.

15. The device according to claim 14, further comprising:
a reflecting film provided on a side surface of the dielectric film,
the lens surface of the dielectric film capable of convergence of the wavelength-converted light.

16. The device according to claim 1 or 14, wherein the substrate includes a Zener diode operable to protect the light emitting element.
